Europäisches Patentamt

European Patent Office

Office européen des brevets

(11) Veröffentlichungsnummer: **0 444 237 A1**

(12) **EUROPÄISCHE PATENTANMELDUNG**

(21) Anmeldenummer: 90115866.7

(22) Anmeldetag: 18.08.90

(51) Int. Cl.5: **H03J 5/02**, H03L 7/199, H03L 7/107

(30) Priorität: 01.12.89 DE 3939709

(43) Veröffentlichungstag der Anmeldung:
04.09.91 Patentblatt 91/36

(84) Benannte Vertragsstaaten:
AT BE CH DE DK ES FR GB GR IT LI LU NL SE

(71) Anmelder: **ROBERT BOSCH GmbH**
**Postfach 10 60 50**
**W-7000 Stuttgart 10(DE)**

(72) Erfinder: **Gorzel, Heribert, Dipl.-Ing.**
**Forstweg 33 c**
**W-1000 Berlin 28(DE)**

(74) Vertreter: **Schmidt, Hans-Ekhardt, Dipl.-Ing.**
**Robert Bosch GmbH Geschäftsbereich**
**Mobile Kommunikation Patent- und**
**Lizenzabteilung Forckenbeckstrasse 9-13**
**W-1000 Berlin 33(DE)**

(54) **Verfahren zur Abstimmung eines Funksende- und/oder -empfangsgerätes.**

(57) Bekannte Verfahren zum Abstimmen eines Funksende- und -empfangsgerätes mit mikroprozessorgesteuerter PLL-Schaltung haben entweder hohe Einschwingzeiten oder sind bei niedrigeren Einschwingzeiten schaltungstechnisch sehr aufwendig. Die Aufgabe der Erfindung besteht darin, die bekannten Verfahren derart zu verbessern, daß das Umschalten der Funkkanäle über ein größeres Frequenzband möglich ist und daß dabei die Umschaltzeiten kleiner als bisher sind.

Die Lösung der Aufgabe besteht darin, daß die Umschaltung in zwei oder mehreren Schritten nacheinander ausgeführt wird, wobei verschieden hohe Vergleichsfrequenzen ($f_V$,$f_V'$) und verschieden hohe Grenzfrequenzen ($f_{g1}$ , $f_{g2}$) des Schleifenfilters (30) der PLL-Schaltung angewendet werden.

Die Zeichnung zeigt ein Blockschaltbild einer modulierbaren PLL-Schaltung.

EP 0 444 237 A1

## VERFAHREN ZUR ABSTIMMUNG EINES FUNKSENDE- UND/ODER -EMPFANGSGERÄTES

Die Erfindung geht von einem Verfahren nach dem Oberbegriff des Anspruchs 1 aus.

Stand der Technik

Bei bekannten derartigen Verfahren werden zum Beispiel Schleifenfilter verwendet, die beim Einschleifenkonzept auf eine hohe Grenzfrequenz für einen Kanalsprung und auf eine tiefe Grenzfrequenz für die Modulation umschaltbar sind. Dabei ergeben sich je nach Wahl der Parameter Einschwingzeiten von 20 bis 100 ms. Kürzere Einschwingzeiten können mit einem Zweischleifenkonzept erzielt werden. Dabei wird die erste Schleife für den Modulationsbetrieb mit einer Grenzfrequenz betrieben, die klein gegenüber der tiefsten Modulationsfrequenz ist. Die zweite Schleife zur Kanalumschaltung hat eine Grenzfrequenz, die klein gegenüber der Vergleichsfrequenz ist. Die Zweischleifenlösung ist schaltungstechnisch sehr aufwendig.

Aufgabe

Der Erfindung liegt die Aufgabe zugrunde, ein Verfahren zur Abstimmung eines Funksendeund/oder -empfangsgerätes anzugeben, das eine Kanalumschaltung über ein größeres Frequenzband ermöglicht und dabei kurze Umschaltzeiten (< 10 ms) zwischen beliebigen Funkkanälen aufweist.

Lösung

Diese Aufgabe wird bei einem Verfahren gemäß dem Oberbegriff des Anspruchs 1 durch die im kennzeichnenden Teil dieses Anspruchs angegebenen Merkmale gelöst. Durch das Umschalten wird eine im Vergleich zu den bekannten Verfahren schnellere Annäherung an den Sollzustand der PLL-Schaltung erreicht. Weiterbildungen und vorteilhafte. Ausgestaltungen des Verfahrens ergeben sich aus den Unteransprüchen.

Beschreibung

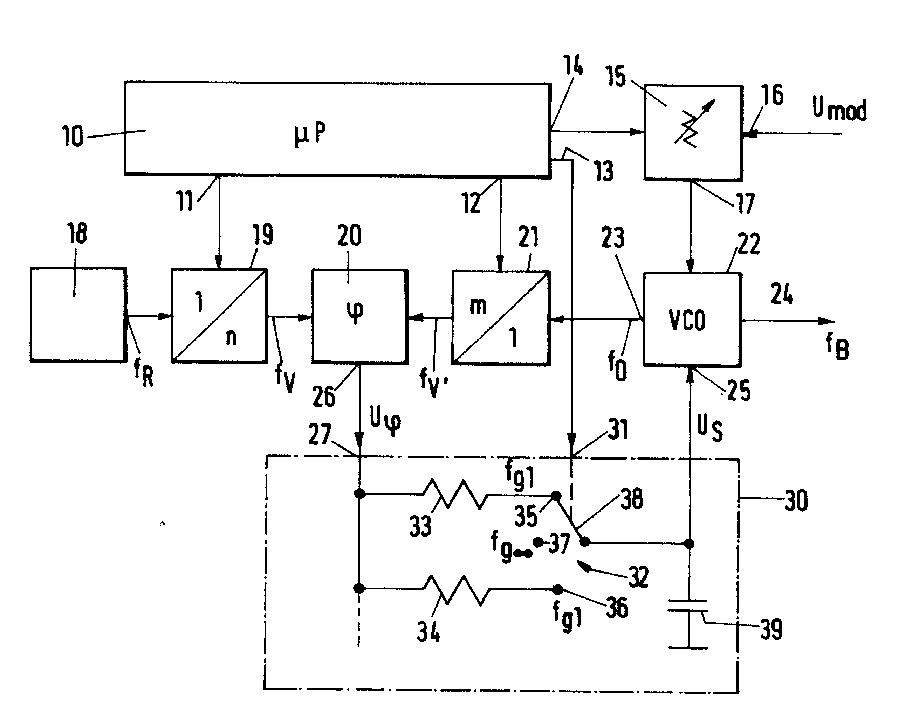

Ein Ausführungsbeispiel der Erfindung ist in der Zeichnung an Hand einer einzigen Figur dargestellt und wird im folgenden näher beschrieben. Die Zeichnung zeigt ein Blockschaltbild einer modulierbaren Kanal-PLL-Schaltung.

In der in der Figur gezeigten PLL-Schaltung bezeichnet 10 einen Mikroprozessor mit vier Ausgängen 11, 12, 13 und 14. Der erste Ausgang 11 ist mit dem Steuereingang eines ersten Frequenzteilers 19, der zweite Ausgang 12 mit einem Steuereingang eines zweiten Frequenzteilers 21, der dritte Ausgang 13 mit einem Steuereingang 31 eines Umschalters 32 und der vierte Ausgang 14 mit einem Steuereingang eines Potentiometers 15 verbunden. Das Potentiometer 15 weist einen Modulationseingang 16 für eine tonfrequente Modulationsspannung $U_{mod}$ und einen Ausgang 17 auf, der mit einem ersten Steuereingang eines spannungsgesteuerten Oszillators 22 verbunden ist.

Ein Referenzfrequenzoszillator 18 steht über den ersten Frequenzteiler 19 mit einem ersten Eingang einer Phasenvergleichsschaltung 20 in Verbindung, deren zweiter Eingang über den zweiten Frequenzteiler 21 mit einem ersten Ausgang 23 des spannungsgesteuerten Oszillators 22 in Verbindung steht. Der spannungsgesteuerte Oszillator 22 weist noch einen zweiten Ausgang 24 und einen zweiten Steuereingang 25 auf. Der zweite Ausgang 24 entspricht dem Ausgang der PLL-Schaltung. Ein Aus gang 26 der Phasenvergleichsschaltung 20 ist mit einem Eingang 27 eines Schleifenfilters 30 verbunden. An diesen Eingang schließen sich zwei parallele Zweige bildende Widerstände 33 und 34 an, von denen der Widerstand 33 mit einem ersten feststehenden Kontakt 35 und der Widerstand 34 mit einem dritten feststehenden Kontakt 36 des Umschalters 32 verbunden ist. Zwischen den beiden Kontakten 35 und 36 befindet sich ein dritter Kontakt (Leerkontakt) 37. Ein beweglicher Kontakt 38 des Umschalters 32 ist mit dem Steuereingang 31 des Schleifenfilters 30 verbunden. An den beweglichen Kontakt 38 schließen sich der zweite Steuereingang 25 des spannungsgesteuerten Oszillators 22 sowie ein Kondensator 39 an, der mit Masse verbunden ist.

Durch eine gestrichelte Linie ist in dem Schleifenfilter 30 angedeutet, daß außer den Widerständen 33 und 34 noch weitere Widerstände vorhanden sein können, die über weitere Kontakte des Umschalters einschaltbar sind.

Die Funktion der vorstehend beschriebenen PLL-Schaltung ist folgende.

Der Mikroprozessor 10 wird als zentrale Steuereinheit für die modulierbare Kanal-PLL-Schaltung verwendet. Dieser steuert über seine Ausgänge 11 bis 14 die programmierbaren Frequenzteiler 19 und 21, die Grenzfrequenz $f_g$ des Schleifenfilters 30 und das programmierbare Potentiometer 15. Dem ersten Frequenzteiler 19 wird die Referenzfrequenz $f_R$ des Referenzfrequenzoszillators 18 und dem zweiten Frequenzteiler 21 die Frequenz $f_0$ des spannungsgesteuerten Oszillators 22 zugeführt. Die durch die Freqenzteilungen erhaltenen Frequenzen werden als Vergleichsfrequenzen $f_V$ und $f_V'$ den Eingängen der Phasenvergleichsschaltung 20 zugeführt. Die von der Differenz der Vergleichsfrequenzen abhängige und am Ausgang 26 liegende Phasenvergleichsspannung

$$U_\varphi$$

wird an den Eingang 27 des Schleifenfilters 30 weitergeleitet, in welchem sie geglättet wird. Die Ausgangsspannung $U_S$ des Schleifenfilters 30 wird als Regelgröße an den spannungsgesteuerten Oszillator 22 weitergeleitet. Im eingeschwungenen Zustand der PLL-Schaltung sind die Vergleichsfrequenzen $f_V$ und $f_V'$ identisch und haben lediglich noch eine geringe Phasenabweichung.

Das Schleifenfilter 30 ist in der Zeichnung zur einfacheren Erläuterung seiner Funktion als passives, umschaltbares RC-Glied 33, 39; 34, 39 dargestellt. Die Umschaltung der RC-Glieder erfolgt durch den Umschalter 32.

Im einzelnen steuert der Mikroprozessor 10 folgende Schritte nacheinander.

Mit den Frequenzteilern 19, 21 werden zunächst Vergleichsfrequenzen $f_V$ und $f_V'$ eingestellt, die höher als das vorgegebene Frequenzraster sind. Bei einem Frequenzraster von zum Beispiel 5 kHz haben die Vergleichsfrequenzen $f_V$ und $f_V'$ einen Wert von zum Beispiel 50 kHz. Die erste Grenzfrequenz $f_{g1}$ des Schleifenfilters 30 wird dabei so bemessen, daß die Stabilitätskriterien erfüllt werden. In dem angenommenen Beispiel liegt die Grenzfrequenz $f_{g1}$ bei ca. 5 kHz. Ist die PLL-Schaltung eingeschwungen, so schaltet der Mikroprozessor 10 den Umschalter 32 in die zweite Schaltstellung, in welcher kein Widerstand eingeschaltet wird ($R = \infty$) bzw. das Filter 30 unterbrochen wird. Der spannungsgesteuerte Oszillator 22 behält dabei seine Frequenz bei, da sich der Kondensator 39 zwischenzeitlich auf eine Spannung $U_S$ aufgeladen hat und diese solange beibehält, bis der Mikroprozessor 10 die Frequenzteiler 19 und 21 derart umgeschaltet hat, daß sich Vergleichsfrequenzen $f_V$ und $f_V'$ ergeben, die dem Kanalraster entsprechen. Der Mikroprozessor 10 schaltet dann den Umschalter 32 in seine dritte Schaltstellung, in welcher nur der zweite Widerstand 34 eingeschaltet ist. Dieser Widerstand ist derart bemessen, daß sich eine Grenzfrequenz $f_{g2}$ ergibt, die unter Berücksichtigung der Stabilitätskriterien der PLL-Schaltung so hoch wie möglich ist. Betragen die Vergleichsfrequenzen $f_V$ und $f_V'$ zum Beispiel 5 kHz, dann liegt die Grenzfrequenz $f_{g2}$ bei ca. 300 Hz.

Beide Frequenzsprünge benötigen nur wenige Millisekunden, zum Beispiel 6 ms, bis die PLL-Schaltung bei der endgültigen Frequenz $f_B$ einrastet, die am Ausgang 24 des spannungsgesteuerten Oszillators 22 zur Verfügung steht. Soll die PLL-Schaltung durch eine Tonfrequenz moduliert werden, so wird die Modulationsspannung $U_{mod}$ an den Eingang 16 des Potentiometers 15 gelegt. Nach entsprechender Spannungsteilung, die der Mikroprozessor 10 steuert, wird der spannungsgesteuerte Oszillator moduliert, wobei es zweckmäßig ist, das Schleifenfilter 30 in bekannter Weise auf eine dritte Grenzfrequenz $f_{g3}$ umzuschalten.

Die Grenzfrequenz der Regelschleife kann auch durch eine Phasenvergleichsschaltung mit umschaltbarer Phasensteilheit verändert werden.

**Patentansprüche**

1. Verfahren zum Abstimmen eines Funksende- und -empfangsgerätes auf einen Funkkanal von mehreren einem vorgegebenen Kanalraster angehörenden Funkkanälen mittels einer PLL-Schaltung, deren Schleifenfilter eine umschaltbare Grenzfrequenz hat, **dadurch gekennzeichnet**, daß der bei einer Umschaltung von einem Funkkanal auf einen anderen Funkkanal erforderliche schnelle Frequenzsprung in zwei oder mehrere nacheinander auszuführende Frequenzsprünge mit verschieden hohen Vergleichsfrequenzen ($f_V, f_V'$) und verschieden hohen Grenzfrequenzen ($f_{g1}$, $f_{g2}$) des Schleifenfilters (30) aufgeteilt wird.

2. Verfahren zum Abstimmen eines Funksende- und -empfangsgerätes auf einen Funkkanal von mehreren einem vorgegebenen Kanalraster angehörenden Funkkanälen mittels einer PLL-Schaltung, **dadurch gekennzeichnet**, daß der bei einer Umschaltung von einem Funkkanal auf einen anderen Funkkanal erforderliche schnelle Frequenzsprung in zwei oder mehrere nacheinander auszuführende Frequenzsprünge mit verschieden hohen Vergleichsfrequenzen ($f_V, f_V'$) und verschieden großen Phasensteilheiten der Phasenvergleichsschaltung (20) aufgeteilt wird.

3. Verfahren nach Anspruch 1, gekennzeichnet durch folgende Schritte:
   a) Mittels zweier Frequenzteiler (19, 21) der PLL-Schaltung werden die Vergleichsfrequenzen ($f_V, f_V'$) auf Werte eingestellt, die höher als das vorgegebene Frequenzraster sind;
   b) eine erste Grenzfrequenz ($f_{g1}$) des Schleifenfilters (30) wird auf einen möglichst hohen, die Stabilitätsanforderungen erfüllenden Wert eingestellt;
   c) das Schleifenfilter (30) wird kurzzeitig unterbrochen und wieder eingeschaltet;
   d) die Vergleichsfrequenzen ($f_V, f_V'$) werden auf Werte eingestellt, die dem Kanalraster entsprechen;

e) eine zweite Grenzfrequenz ($f_{g2}$) des Schleifenfilters (30) wird unter Berücksichtigung der Stabilitätsanforderungen so hoch wie möglich eingestellt.

# EUROPÄISCHER RECHERCHENBERICHT

**EP 90 11 5866**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 6, Nr. 81 (E-107)[959], 19. Mai 1982; & JP-A-57 20 037 (TOKYO SHIBAURA DENKI) 02-02-1982 * Zusammenfassung; Figuren 3,4 * | 1,3 | H 03 J 5/02 H 03 L 7/199 H 03 L 7/107 |
| | – – – | | |
| X | FR-A-2 128 056 (THOMSON-CSF) * Seite 1, Zeile 39 - Seite 7, Zeile 13; Seite 9, Zeilen 31-34; Figuren 1-3 * | 2 | |
| | – – – | | |
| A | US-A-4 516 083 (TURNEY) * Spalte 2, Zeile 41 - Spalte 5, Zeile 32; Figuren 1,2 * | 1-3 | |
| | – – – – – | | |

| RECHERCHIERTE SACHGEBIETE (Int. Cl.5) |
|---|
| H 03 L H 03 J |

Der vorliegende Recherchenbericht wurde für alle Patentansprüche erstellt

| Recherchenort | Abschlußdatum der Recherche | Prüfer |
|---|---|---|
| Den Haag | 28 März 91 | BALBINOT H. |